# EUROPEAN PATENT APPLICATION

(11) **EP 4 549 978 A1**
(43) Date of publication of application: **07.05.2025**
(21) Application number: 23860505.9
(22) Date of filing: 31.08.2023
(51) Int. Cl.: G01R 33/02, H10N 50/00, H10N 50/80

(54) **MAGNETIC SENSOR DEVICE**

(30) Priority: 02.09.2022 JP 2022139958
(71) Applicant: Aichi Steel Corporation, Tokai-shi, Aichi 476-8666 (JP)
(72) Inventor: SHIMIZU Yusuke, Tokai-shi, Aichi 476-8666 (JP); IWANAGA Yoshihiro, Tokai-shi, Aichi 476-8666 (JP); TATEMATSU Shunichi, Tokai-shi, Aichi 476-8666 (JP)
(74) Representative: Kramer Barske Schmidtchen Patentanwälte PartG mbB
(86) International application number: PCT/JP2023/031891
(87) International publication number: WO 2024/048743

(57) **Abstract**

A magnetic sensor device (1) includes a wiring board (2), a plurality of magnetic detection elements (4) mounted on the wiring board (2), and a rectangular integrated circuit (3) electrically connected to the plurality of magnetic detection elements (4). The plurality of magnetic detection elements (4) is disposed outside the integrated circuit (3) when viewed in a direction normal to the wiring board (2). The magnetic detection elements (4) whose magnetism sensing directions are parallel to each other are disposed at least at positions along two edges (31a), (31b), (31c), and (31d) of the integrated circuit (3), the two edges being opposite each other.

## Description

### TECHNICAL FIELD

The present invention relates to a magnetic sensor device.

### BACKGROUND ART

For example, Patent Literature 1 discloses a magnetic sensor device.

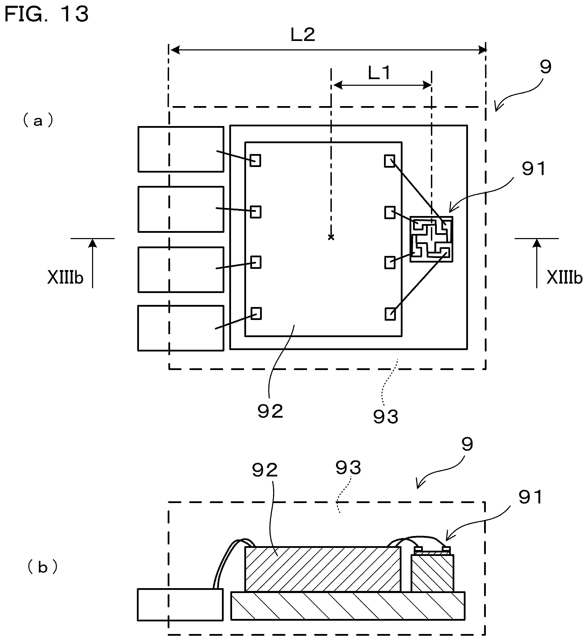

A conventional magnetic sensor device disclosed in Patent Literature 1 will be described below with reference to Fig. 13. As illustrated in Fig. 13(a), a magnetic sensor device 9 includes a Hall element 91 having a cross-shaped magnetism sensing portion formed of a semiconductor layer formed on or in a substrate, and an integrated circuit 92 to which a signal is input from the Hall element 91, and the Hall element 91 and the integrated circuit 92 are provided in a rectangular resin package 93. As illustrated in Fig. 13(b), the Hall element 91 and the integrated circuit 92 are connected by a bonding wire, and the integrated circuit 92 and an external pad electrically connected to the outside are connected by a bonding wire.

As described above, the magnetic sensor device 9 is configured by a system in package (Sip).

In the magnetic sensor device 9, as shown in Fig. 13(a), in plan view of the device main body, the magnetism sensing portion is disposed at a position where the distance L1 from the center position of the device main body to the center of the magnetism sensing portion is 10% or more and 32% or less of the length L2 of the magnetic sensor device 9 in the axial direction of the straight line connecting the center of the device main body and the center of the cross shape of the magnetism sensing portion.

In the magnetic sensor device 9, in plan view of the device main body, each axis formed by two sides constituting the cross shape of the magnetism sensing portion is perpendicular or parallel to a long side of the rectangular resin package 93.

In recent years, system development by a magnetic sensor device using a plurality of magnetic detection elements has been active. For example, the above system is applied in the industrial field of food foreign matter detection devices, the transportation equipment field of automatic driving devices, and the medical field of measuring a brain and a heart. A common point of the above three fields is that a plurality of magnetic detection elements is provided to detect the position of an object with higher accuracy. Therefore, information obtained from the magnetic sensor device is one of very important items. Not limited to the above three fields, in recent years, a magnetic sensor device on which a plurality of magnetic detection elements is mounted is required, and detection accuracy thereof is also required to be higher.

### PRIOR ART LITERATURE

### PATENT LITERATURE

Patent Literature 1: JP 2014-163702 A

### SUMMARY OF INVENTION

### PROBLEMS TO BE SOLVED BY INVENTION

However, the magnetic sensor device disclosed in Patent Literature 1 includes one Hall element mounted on a substrate, and a configuration in which a plurality of magnetic detection elements is disposed on the substrate is not described in Patent Literature 1.

On the other hand, as described above, it is desired to perform magnetic detection using a plurality of magnetic detection elements whose magnetism sensing directions are parallel to each other.

In such a magnetic sensor device, the positional relationship between the integrated circuit and the plurality of magnetic detection elements can be an important factor in facilitating highly accurate magnetic detection and reducing the size of the device. However, Patent Literature 1 only shows a magnetic sensor device on which one Hall element (magnetic detection element) is mounted as described above, and thus does not consider a positional relationship between an integrated circuit and a plurality of magnetic detection elements.

In view of the above problems, an object of the present invention is to provide a magnetic sensor device that facilitates highly accurate magnetic detection and facilitates miniaturization.

### MEANS FOR SOLVING PROBLEM

In order to solve the above problem, a magnetic sensor device according to an aspect of the present disclosure includes:
a wiring board;
a plurality of magnetic detection elements mounted on the wiring board; and
an integrated circuit mounted on the wiring board and electrically connected to the magnetic detection elements, the integrated circuit having a rectangular shape, wherein
the plurality of magnetic detection elements is disposed outside the integrated circuit when viewed in a direction normal to the wiring board, and
the magnetic detection elements whose magnetism sensing directions are parallel to each other are disposed at least at positions along two edges of the integrated circuit, the two edges being opposite each other.

### EFFECTS OF INVENTION

In the magnetic sensor device, the magnetic detection elements whose magnetism sensing directions are parallel to each other are disposed at least at positions along two edges of the integrated circuit, the two edges being opposite each other. Therefore, it is easy to downsize the entire magnetic sensor device while shortening distances between the plurality of magnetic detection elements and the integrated circuit and suppressing the variation in the distances. That is, by shortening the distances between the plurality of magnetic detection elements and the integrated circuit and suppressing variations in the distances, it is possible to suppress superimposition of noise on an electric signal and to perform detection with high accuracy. In addition, with the arrangement relationship between the integrated circuit and the plurality of magnetic detection elements as described above, it is easy to make the mounting space of these elements on the wiring board compact, and it is easy to miniaturize the magnetic sensor device.

As described above, according to the above aspect, it is possible to provide a magnetic sensor device that facilitates highly accurate magnetic detection and facilitates miniaturization.

### BRIEF DESCRIPTION OF DRAWINGS

Fig. 1 is a plan view of a magnetic sensor device according to a first embodiment.
Fig. 2 is a plan view of the magnetic sensor device for describing arrangement of relay pads and assembly alignment marks according to the first embodiment.
Fig. 3 is a plan view of the magnetic sensor device in a state where an integrated circuit and a magnetic detection element are removed according to the first embodiment.
Fig. 4 is a cross-sectional view taken along line IV-IV in Fig. 1.
Fig. 5 is a cross-sectional view taken along line V-V in Fig. 1.
Fig. 6 is a plan view of an MI element according to the first embodiment.
Fig. 7 is a block diagram of the integrated circuit according to the first embodiment.
Fig. 8 is diagrams for describing (a) an example of a method of detecting a target magnetic field assuming a case where the target magnetic field is strong, and (b) an example of a method of detecting a target magnetic field assuming a case where the target magnetic field is weak according to the first embodiment.
Fig. 9 is a diagram illustrating an example of a means for detecting a position of an object according to the first embodiment.
Fig. 10 is a plan view of a magnetic sensor device in a second embodiment.
Fig. 11 is a plan view of a magnetic sensor device according to a third embodiment.
Fig. 12 is a plan view of a magnetic sensor device according to a fourth embodiment.
Fig. 13(a) is a plan view illustrating a configuration of a conventional magnetic sensor device, and Fig. 13(b) is a cross-sectional view taken along line XIIIb-XIIIb in Fig. 13(a).
Fig. 14 is a plan view of a magnetic sensor device in a fifth embodiment.
Fig. 15 is a plan view of an integrated circuit in the fifth embodiment.
Fig. 16 is a plan view of an analog circuit unit in the fifth embodiment.
Fig. 17 is a plan view of a back face of the integrated circuit in the fifth embodiment.
Fig. 18 is a cross-sectional view of the magnetic sensor device in the fifth embodiment.
Fig. 19 is a plan view of a magnetic sensor device in a sixth embodiment.
Fig. 20 is a circuit diagram of part of the magnetic sensor device in the sixth embodiment.
Fig. 21 is a plan view of a magnetic sensor device in a seventh embodiment.

### MODE FOR CARRYING OUT INVENTION

Hereinafter, embodiments will be specifically described with reference to the drawings.

Note that the embodiments described below illustrate comprehensive or specific examples, and numerical values, shapes, constituent elements, arrangement positions and connection modes of the constituent elements, and the like shown in the embodiments are merely examples, and are not intended to limit the present disclosure. Further, among the constituent elements in the following embodiments, constituent elements that are not described in independent claims indicating the highest concept are described as arbitrary constituent elements.

Although the magnetic sensor device of the present disclosure is described based on the embodiments, the magnetic sensor device according to the present disclosure is not limited to the following embodiments. The present disclosure also includes the following embodiments, modifications obtained by making various modifications conceivable by those skilled in the art to the following embodiments without departing from the spirit of the present disclosure, and various devices incorporating the magnetic sensor device according to the present disclosure.

### (First embodiment)

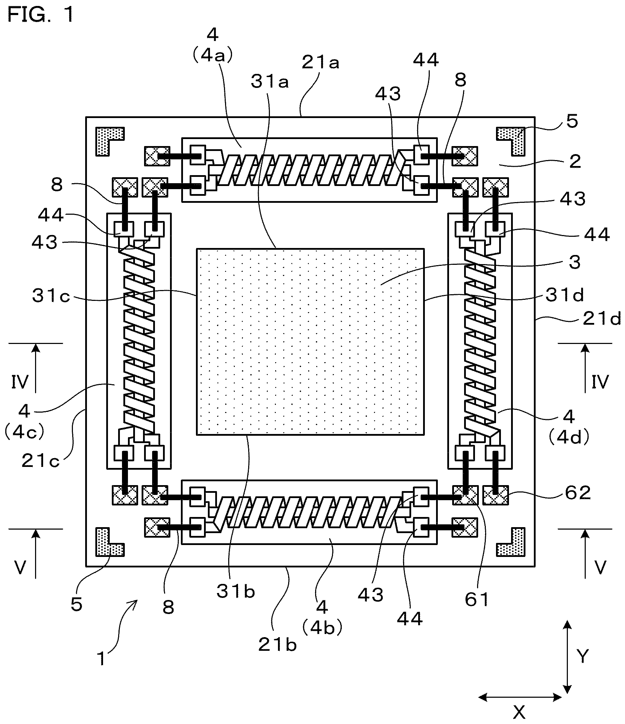

Fig. 1 is a plan view illustrating a configuration example of a magnetic sensor device 1 according to a first embodiment.

In the drawing, the magnetic sensor device 1 includes a rectangular integrated circuit 3 mounted on a wiring board 2, a plurality of magnetic detection elements 4, and relay pads 61 and 62 for electrically connecting the integrated circuit 3 and the magnetic detection elements 4. Assembly alignment marks 5 for positioning the integrated circuit 3 and the magnetic detection elements 4 are formed on the wiring board 2. As will be described later, the relay pads 61 and 62 are connected to the integrated circuit 3 via wiring mounted on the wiring board 2, and the magnetic detection element 4 is connected to the relay pads 61 and 62 via a bonding wire 8. Although not illustrated, the connection with the outside is realized in a connection terminal portion on the back face (Fig. 1 illustrates the front face) of the wiring board 2, and the connection terminal portion is connected to the integrated circuit 3 via the wiring mounted on the wiring board 2.

The integrated circuit 3 is disposed at the center of the wiring board 2 and is smaller than the wiring board 2.

The magnetic detection elements 4 whose magnetism sensing directions are parallel to each other are disposed at least at positions along two edges of the integrated circuit 3, the two edges being opposite each other. The magnetic sensor device 1 includes four or more magnetic detection elements 4. The magnetic detection element 4 is disposed at a position along each of four edges of the integrated circuit 3 when viewed in a direction normal to the wiring board 2. In the present embodiment, four magnetic detection elements 4 are disposed in the magnetic sensor device 1.

Each of the magnetic detection elements 4a, 4b, 4c, and 4d is located outside four edges 31a, 31b, 31c, and 31d of the integrated circuit 3 and inside four edges 21a, 21b, 21c, and 21d of the wiring board 2. The magnetic detection elements 4 disposed along two opposite edges are disposed so that "magnetism sensing directions are parallel to each other". A distance between the magnetic detection element 4a and the edge 31a of the integrated circuit 3 and a distance between the magnetic detection element 4b and the edge 31b of the integrated circuit 3 are equal distances, and a distance between the magnetic detection element 4c and the edge 31c of the integrated circuit 3 and a distance between the magnetic detection element 4d and the edge 31d of the integrated circuit 3 are equal distances. The magnetic detection elements 4a, 4b, 4c, and 4d do not interfere with each other and each have an elongated shape. In addition, the longitudinal direction of each of the magnetic detection elements 4 is parallel to the edge of the integrated circuit 3 on an adjacent side. By disposing the two magnetic detection elements 4 parallel to each other on opposite sides with the integrated circuit 3 interposed therebetween, magnetic interference between the two magnetic detection elements 4 is suppressed.

The magnetism sensing direction of the magnetic detection element 4 represents the direction of magnetism in which the detection sensitivity is maximized, and "the magnetism sensing directions are parallel to each other" means that the magnetism sensing directions are substantially parallel to each other, and a slight non-parallel state that does not cause a problem in actual use is not excluded.

A direction parallel to the pair of edges 31a and 31b, of the integrated circuit 3, parallel to each other, is defined as an X direction. A direction parallel to the other pair of edges 31c and 31d, of the integrated circuit 3, parallel to each other, is defined as an Y direction, the magnetism sensing direction of the magnetic detection elements 4a and 4b disposed with the longitudinal direction facing the X direction is the X direction, and the magnetism sensing direction of the magnetic detection elements 4c and 4d disposed with the longitudinal direction facing the Y direction is the Y direction.

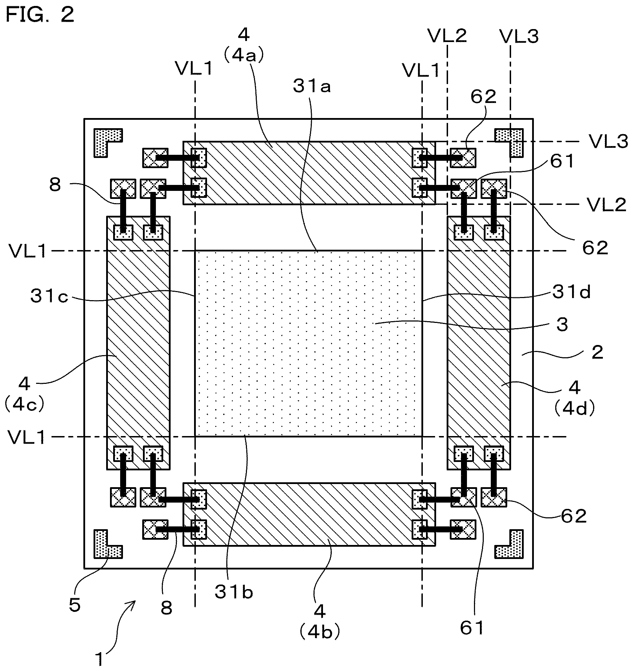

Fig. 2 is a plan view of the magnetic sensor device 1 for describing the arrangement of the relay pads 61 and 62 and the assembly alignment marks 5 according to the first embodiment. However, details of the magnetic detection elements 4 illustrated in Fig. 1 will be omitted.

As illustrated in the drawing, three relay pads 61, 62 are formed near each of the four corners of the wiring board 2, and are formed by printing on the upper face of the wiring board 2. For convenience, in the direction normal to the wiring board 2, a side on which the integrated circuit 3 is mounted on the wiring board 2 (front face in Figs. 1 and 2) is represented as an upper side, and a side opposite to the aforesaid side is represented as a lower side.

When viewed in the direction normal to the wiring board 2, the relay pads 61 and 62 are formed at positions farther from the integrated circuit 3 than a virtual straight line VL1 obtained by extending each of the four edges 31a, 31b, 31c, and 31d of the integrated circuit 3.

When viewed in the direction normal to the wiring board 2, the relay pads 61 and 62 are disposed between virtual straight lines VL2 and VL3 obtained by extending contour lines of both sides of each of the magnetic detection elements 4 in the width direction, and are formed at a position adjacent to the magnetic detection element 4 in the longitudinal direction.

The relay pads 61 and 62 are connected to the magnetic detection elements 4 by the bonding wires 8. As a result, a space on the wiring board 2 is effectively used, and downsizing of the magnetic sensor device 1 is realized. In the present embodiment, since the integrated circuit 3 is not connected to the bonding wires 8, the influence of the inductance by the bonding wires 8 on the integrated circuit 3 is reduced.

The assembly alignment marks 5 are formed by printing at four corners of the wiring board 2, and each have, for example, a substantially L shape. The distance between the alignment mark 5 and the corresponding corner of the wiring board 2 is shorter than the distance between the relay pads 61 and 62 and the corresponding corner of the wiring board 2. The shape of each of the alignment marks 5 is not particularly limited to a substantially L shape, and may be another shape.

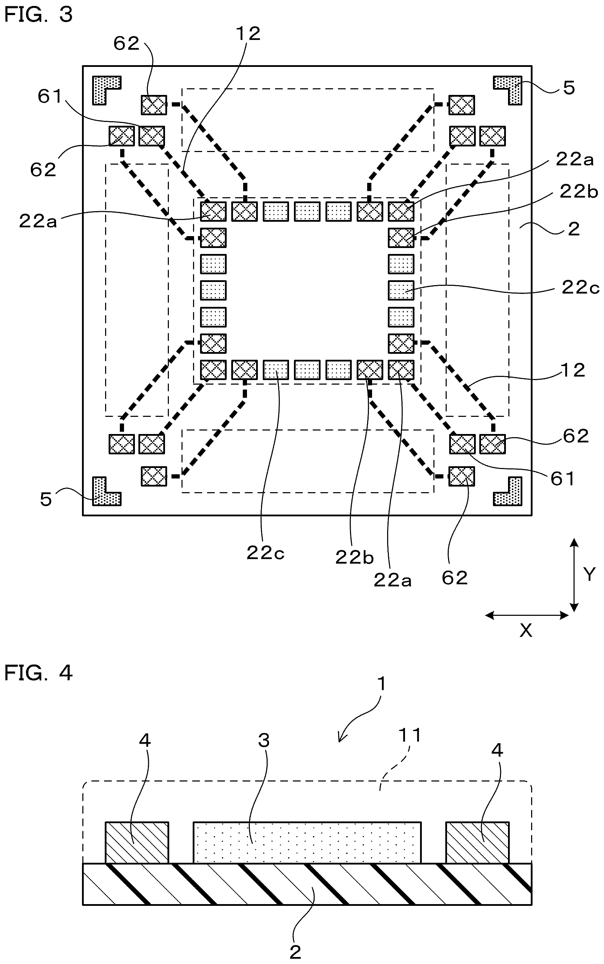

Fig. 3 is a plan view of the magnetic sensor device 1 in a state where the integrated circuit 3 and the magnetic detection elements 4 are removed according to the first embodiment.

As illustrated in the drawing, a connection wiring 12 that connects the relay pads 61 and 62 and the integrated circuit 3 is formed by printing on the inner layer of the wiring board 2. The connection wiring 12 is connected to the relay pads 61 and 62, and the opposite end is connected to the chip connection pads 22a and 22b for connecting the integrated circuit 3 (IC chip).

The chip connection pads 22a, 22b, and 22c are formed on the upper face of the wiring board 2 and disposed at positions where the chip connection pads overlap the integrated circuit 3. The chip connection pad 22a is connected to the connection wiring 12. The chip connection pad 22c is connected to a connection wiring (not illustrated) connected to a terminal electrically connected to the outside.

Fig. 4 is a cross-sectional view taken along line IV-IV in Fig. 1.

As illustrated in the drawing, the integrated circuit 3 is disposed at the center of the wiring board 2 in the left-right direction of the drawing, and the magnetic detection element 4 is disposed with a certain distance from each of the left and right ends of the integrated circuit 3. The left and right magnetic detection elements 4 are disposed inside peripheral ends of the wiring board 2. The integrated circuit 3 and the magnetic detection element 4 are sealed with a sealing resin 11. The sealing resin 11 is formed on the wiring board 2.

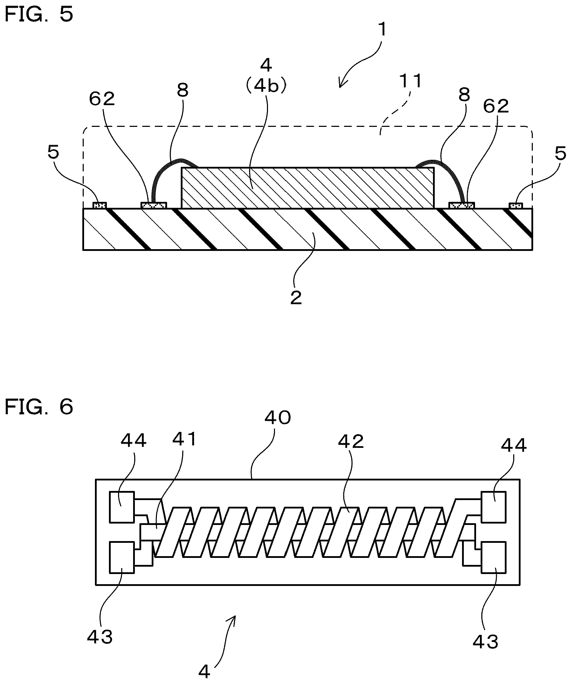

Fig. 5 is a cross-sectional view taken along line V-V in Fig. 1. That is, Fig. 5 is a cross-sectional view of the magnetic sensor device 1 cut by a plane passing through the magnetic detection element 4b disposed along the edge 31b of the integrated circuit 3 and orthogonal to the Y direction.

As illustrated in the drawing, the magnetic detection element 4b is disposed at the center of the wiring board 2 in the left-right direction of the drawing. The relay pad 62 and the assembly alignment mark 5 are disposed with a certain distance from each of the left and right ends of the magnetic detection element 4b. The relay pad 62 is formed by printing on the wiring board 2, and the assembly alignment mark 5 is formed by printing on the wiring board 2 in order from each of the left and right ends of the magnetic detection element 4b toward the end of the wiring board 2.

Also with respect to the other magnetic detection elements 4a, 4b, and 4c, the relay pads 61 and 62, and the alignment mark 5 are formed by printing similarly at a position with a predetermined distance from the both ends thereof in the longitudinal direction (see Figs. 1 and 2).

The assembly alignment marks 5 are located inside the peripheral ends of the wiring board 2. The magnetic detection elements 4 and the relay pads 61 and 62 are connected by the bonding wires 8. The integrated circuit 3, the magnetic detection elements 4, the bonding wires 8, and the alignment marks 5 are sealed with the sealing resin 11. The sealing resin 11 is formed on the wiring board 2.

Fig. 6 is a plan view of an MI element as the magnetic detection element 4 according to the first embodiment.

As the magnetic detection element 4, for example, a magneto-impedance element (in the following description, it is also referred to as an "MI element 4") can be used. Here, the MI element 4 will be described as an example. The MI element 4 includes, on an element substrate 40, a magnetism sensing body 41 made of an amorphous wire, a detection coil 42 wound around the magnetism sensing body 41 with an insulating layer interposed therebetween, a wire pad 43 electrically connected to the outside, and a coil pad 44. An element other than the MI element can be applied as the magnetic detection element 4 as long as the element can detect magnetism.

When the MI element 4 is manufactured, first, a lower half of the detection coil 42 is formed on the element substrate 40 made of an insulator, an insulating film is formed thereon, the magnetism sensing body 41 is disposed thereon, an insulating film is formed thereon again, and an upper half of the detection coil 42 is formed thereon. The lower half and the upper half of the detection coil 42 are electrically and physically connected. That is, the upper half and the lower half of the detection coil 42 are combined to form one detection coil 42. The longitudinal direction of the magnetism sensing body 41 coincides with the longitudinal direction of the MI element 4. When the MI elements 4 are disposed as illustrated in Fig. 1, the longitudinal directions of the magnetism sensing bodies 41 are respectively parallel to the edges 31a, 31b, 31c, and 31d of the integrated circuit 3 on an adjacent side.

Here, a pair of wire pads 43 electrically connected to both ends of the magnetism sensing body 41 and a pair of coil pads 44 electrically connected to both ends of the detection coil 42 are formed by printing on the element substrate 40. The wire pads 43 and the coil pads 44 are formed near both ends of the MI element 4 in the longitudinal direction.

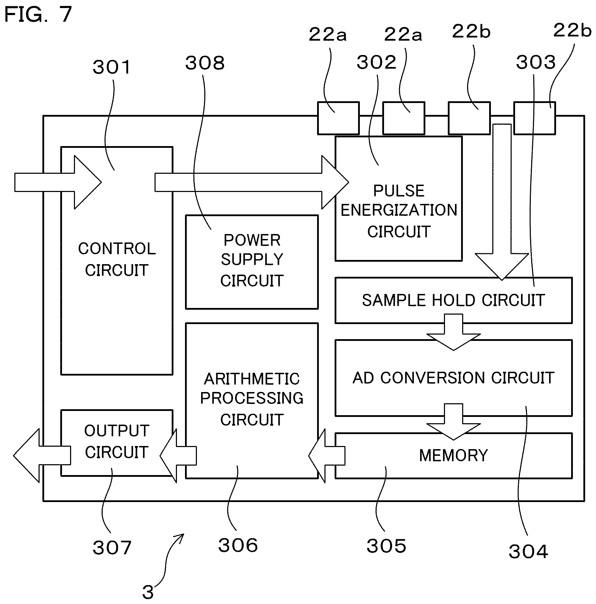

Fig. 7 is a block diagram of the integrated circuit 3 according to the first embodiment.

As illustrated in the drawing, the integrated circuit 3 includes a control circuit 301, a plurality of pulse energization circuits 302, a plurality of sample hold circuits 303, a plurality of analog digital (AD) conversion circuits 304, a plurality of memories 305, an arithmetic processing circuit 306, an output circuit 307, and a plurality of power supply circuits 308.

The control circuit 301 receives external communication (so-called control signal) and controls each circuit. The pulse energization circuit 302 is connected to the chip connection pad 22a connected to the magnetism sensing body 41 of the MI element 4. The pulse energization circuit 302 can control flowing and stopping of a pulse current to the magnetism sensing body 41. By this control, a voltage (induced electromotive force) is generated at both ends of the detection coil 42 of the MI element 4. The sample hold circuit 303 is connected to the chip connection pads 22b connected to both ends of the detection coil 42, and the voltage (signal) generated at both ends of the detection coil 42 is input thereto. Here, the input signal is temporarily stored in the sample hold circuit. Next, the temporarily stored signal is converted from an analog signal to a digital signal by the AD conversion circuit 304. The signal converted into the digital signal is temporarily stored in the memory 305. The signal stored in the memory 305 is transmitted to the arithmetic processing circuit 306. The arithmetic processing circuit 306 performs, for example, calculation for suppressing individual variation, calculation of position detection of an object, and the like. The output circuit 307 outputs the result of the arithmetic processing circuit 306 to the outside of the integrated circuit 3. The power supply circuit 308 supplies a desired power supply voltage to the pulse energization circuit 302, the AD conversion circuit 304, and an amplifier circuit (not illustrated). The AD conversion circuit 304 has a gain amplifier (amplifier circuit) function capable of flexibly amplifying the analog signal.

Communication methods for exchanging information from the outside include, for example, a two-wire synchronous serial interface inter-integrated circuit (I2C) and a three-wire synchronous serial communication, but in the present invention, there is no interface restriction. Any communication scheme may be applied.

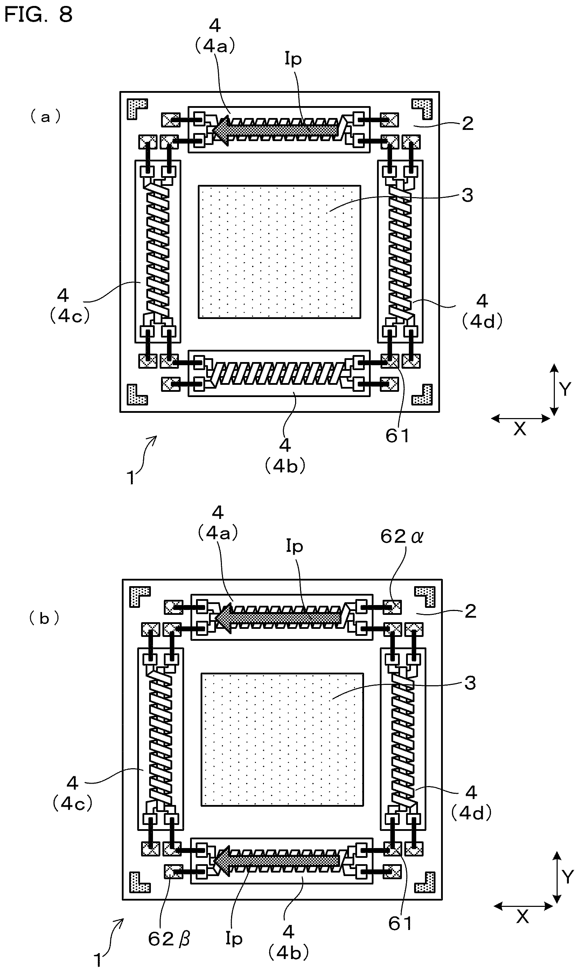

Fig. 8 is a diagram illustrating an example of a means for detecting a measurement target magnetic field with high accuracy by the magnetic sensor device 1 according to the first embodiment.

First, detection of a magnetic field will be specifically described.

The MI element 4 detects an induced electromotive force generated in the detection coil 42 when a pulse current is input to the magnetism sensing body 41, thereby detecting the strength of the magnetic field acting in the magnetism sensing direction of the MI element 4. That is, the MI element 4a and the MI element 4b whose magnetism sensing direction is the X direction detect a magnetic field component in the X direction, and the MI element 4c and the MI element 4d whose magnetism sensing direction is the Y direction detect a magnetic field component in the Y direction. Therefore, by combining the detection signals of the four MI elements 4a, 4b, 4c, and 4d, the direction and strength of the magnetic field along the X-Y plane can be detected.

Fig. 8(a) is an explanatory diagram assuming a case where the target magnetic field is strong, and Fig. 8(b) is an explanatory diagram assuming a case where the target magnetic field is weak.

In a case where the measurement target magnetic field is strong, as illustrated in Fig. 8(a), the pulse current Ip is input from the right side to the left side only to the magnetism sensing body 41 of the MI element 4a of the two MI elements 4a and 4b, and the induced electromotive force generated in the detection coil 42 is detected.

When the measurement target magnetic field is weak, as illustrated in Fig. 8(b), the pulse current Ip flows in the same direction to both the magnetism sensing body 41 of the MI element 4a and the magnetism sensing body 41 of the MI element 4b. At this time, the detection coil 42 of the MI element 4a and the detection coil 42 of the MI element 4b are electrically connected via the relay pad 62α, the integrated circuit 3, and the relay pad 62β. As a result, the two MI elements 4a and 4b are functionally integrated, the number of turns of the detection coil is doubled, and the detection accuracy is improved. That is, the induced electromotive force V generated at both ends of the detection coil 42 is ideally twice as large as that in the case of detecting with only one MI element 4, and in particular, in a case where the measurement target magnetic field is weak, it is important to increase the measurement accuracy. The expression of the induced electromotive force V can be expressed by V = -Ndφ/dt according to the Lenz's law. N is the number of windings of the coil, dφ is a magnetic flux change, and dt is a time change.

Here, in a case where the measurement target magnetic field is strong, if the two MI elements 4 are functionally integrated as illustrated in Fig. 8(b), the induced electromotive force V exceeds the measurement range, and the measurement may be impossible. Therefore, by combining the method illustrated in Fig. 8(a) and the method illustrated in Fig. 8(b), that is, by using them properly, it is possible to accurately perform detecting in a case where the measurement target magnetic field is strong and in a case where the measurement target magnetic field is weak. That is, a wide dynamic range can be secured.

In the above description, the magnetic field measurement of the X-direction component using the MI elements 4a and 4b is described. However, a wide dynamic range can be achieved by a similar method, also for the magnetic field measurement of the Y-direction component using the MI elements 4c and 4d.

In addition to the above, a means for improving the detection accuracy includes, for example, a means for adding a detection value A of the MI element 4a and a detection value B of the MI element 4b by the AD conversion circuit 304 of the integrated circuit 3, that is, a means for setting A + B as a value of the detection result. Furthermore, for the detection sensitivity of the MI element 4a and the MI element 4b, there is also a means for performing detection by, for example, applying a gain of 0 dB (one time) to a signal of the MI element 4a and applying a gain of 60 dB (1000 times) to the signal of the MI element 4b with respect to an object using the AD conversion circuit 304 in the integrated circuit 3, and calculating the strength of the magnetic field of the object based on the above two detection results.

Next, an example of a means for reducing the influence of individual variations of the MI elements 4 in the magnetic sensor device 1 according to the first embodiment will be described below.

There may be individual variations in sensitivity between the plurality of MI elements 4. Therefore, by performing the averaging processing of the outputs of the two MI elements 4, the influence of the individual variations of the MI elements 4 on the measurement by the magnetic sensor device 1 can be reduced. For example, the detection values of the MI element 4a and the MI element 4b in the X direction are averaged by the integrated circuit 3 with the same magnetism sensing direction. The same applies to the averaging of the detection value of the MI element 4c and the detection value of the MI element 4d in the Y direction. Thus, by averaging the detection values in the X direction and the detection values in the Y direction, the sensitivity variation among the MI elements 4 is reduced. That is, the detection accuracy of the magnetic field in the X direction and the Y direction is improved.

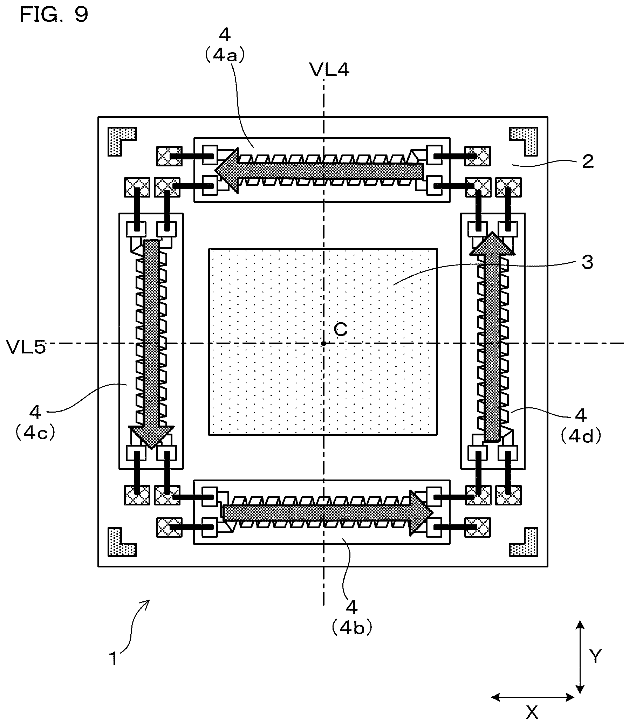

Next, a means for detecting the position of an object (magnetic field generation source) using the magnetic sensor device 1 of the present embodiment will be described with reference to Fig. 9. For example, the MI element 4a and the MI element 4b in the X direction have magnetism sensing directions opposite to each other, and the MI element 4c and the MI element 4d in the Y direction have magnetism sensing directions opposite to each other. For example, pulse currents Ip in opposite directions are applied to the magnetism sensing body 41 of the MI element 4a and the magnetism sensing body 41 of the MI element 4b, and pulse currents Ip in opposite directions are applied to the magnetism sensing body 41 of the MI element 4c and the magnetism sensing body 41 of the MI element 4d. After that, magnetism is detected to detect the position of the object. In this example, the MI elements 4a and 4b can perform simultaneously detection (detection 1), but the MI elements 4c and 4d do not perform detection (detection 2) while the MI elements 4a and 4b are performing detection. It is assumed that the detection 2 is started after the detection 1 ends. Conversely, it can also be assumed that the detection 1 is started after the detection 2 ends. The time shift between the detection 1 and the detection 2 has a minor influence on the detection result of the position of the object by the magnetic field detection by the MI elements 4a, 4b, 4c, and 4d.

Here, for example, the region where the object is detected can be roughly divided into four. That is, when the X direction and the Y direction are divided by a virtual straight line VL4 in the Y direction and a virtual straight line VL5 in the X direction intersecting at a central position C of the magnetic sensor device 1, the region can be divided into four.

When the object is located at the center (the position of the point C in Fig. 9, that is, the position which is the center between the MI element 4a and the MI element 4b and the center between the MI element 4c and the MI element 4d) of the magnetic sensor device 1, ideally, the output values of the MI element 4a and the MI element 4b having the magnetism sensing direction in the X direction have the same magnitude and opposite signs. Therefore, ideally, the combined value of the output value of the MI element 4a and the output value of the MI element 4b is 0. Similarly, the output values of the MI element 4c and the MI element 4d having the magnetism sensing direction in the Y direction have the same magnitude and opposite signs. Therefore, ideally, the combined value of the output value of the MI element 4a and the output value of the MI element 4b is 0. Here, when the object is located in an upper left region of the magnetic sensor device 1 in Fig. 9 (a region to the left of the virtual straight line VL4 and above the virtual straight line VL5), the detection value of the MI element 4a is larger than that of the MI element 4b, and the detection value of the MI element 4c is larger than that of the MI element 4d. For example, when the object is located in a lower right region of the magnetic sensor device 1 in Fig. 9, the detection value of the MI element 4b is larger than that of the MI element 4a, and the detection value of the MI element 4d is larger than that of the MI element 4c.

In this way, the output value of each of the MI elements 4a, 4b, 4c, and 4d varies depending on the position of the object with respect to the magnetic sensor device 1. Using this, the position of the object can be detected.

The magnetism sensing direction of the MI element 4 can be easily switched by the integrated circuit 3.

As described above, according to the magnetic sensor device 1 of the first embodiment described with reference to the drawings, for example, it is possible to realize the wide dynamic range in which a weak signal to a strong signal can be received, low noise in which the influence of individual variation is suppressed by averaging a plurality of MI elements, and highly accurate detection of the position of the object.

Note that the method of using the magnetic sensor device 1 of the present embodiment is not limited to the above. Depending on the method of use (purpose of use), the magnetic sensor device 1 can be used by variously changing the manner of energizing the pulse current to the plurality of MI elements 4, the manner of connecting the detection coils 42 of the plurality of MI elements 4, and the like by the integrated circuit 3.

In the magnetic sensor device 1, the magnetic detection elements 4 whose magnetism sensing directions are parallel to each other are disposed at least at positions along two edges of the integrated circuit 3, the two edges being opposite each other. Therefore, while shorting the distances between the plurality of magnetic detection elements 4 and the integrated circuit 3 and suppressing the variation in the distances, it is easy to downsize the entire magnetic sensor device 1. That is, by shortening the distances between the plurality of magnetic detection elements 4 and the integrated circuit 3 and suppressing the variation in the distances, it is possible to suppress superimposition of noise on an electric signal and to perform detection with high accuracy. In addition, with the arrangement relationship between the integrated circuit 3 and the plurality of magnetic detection elements 4 as described above, it is easy to make the mounting space for these elements on the wiring board 2 compact, and it is easy to miniaturize the magnetic sensor device 1.

In addition, by disposing the two magnetic detection elements 4 parallel to each other on opposite sides with the integrated circuit 3 interposed therebetween, it is easy to suppress magnetic interference between the two magnetic detection elements 4.

The longitudinal directions of the MI elements 4 are respectively parallel to the edges 31a, 31b, 31c, and 31d of the integrated circuit 3 on an adjacent side.

The magnetic detection elements 4 are disposed at positions along the four edges 31a, 31b, 31c, and 31d of the integrated circuit 3 when viewed in the direction normal to the wiring board 2. As a result, the four magnetic detection elements 4 can be compactly disposed on the wiring board 2. As a result, downsizing of the magnetic sensor device 1 including the four magnetic detection elements 4 can be easily performed, and detection accuracy can be effectively improved.

When viewed in the direction normal to the wiring board 2, the bonding wires 8 are disposed at positions where the bonding wires do not overlap the integrated circuit 3. As a result, it is possible to suppress the influence of the magnetic field caused by the current flowing through the bonding wires 8 on the integrated circuit 3. As a result, noise can be effectively reduced, and highly accurate magnetic detection can be facilitated.

Further, the relay pads 61 and 62 are disposed at positions farther from the integrated circuit 3 than the virtual straight line VL1 when viewed in the direction normal to the wiring board 2. As a result, the space on the wiring board 2 can be effectively used to further downsize the magnetic sensor device 1.

Since the magnetic detection elements 4 are MI elements, the detection accuracy can be further improved and the device can be further downsized.

In the magnetic sensor device 1 of the present embodiment, as illustrated in Fig. 1, the distances between the integrated circuit 3 and the plurality of magnetic detection elements 4 are short and substantially equal. Therefore, the signals obtained from the plurality of magnetic detection elements 4 ideally have the same value except for individual variations of the magnetic detection elements 4. In addition, since the distances between the integrated circuit 3 and the plurality of magnetic detection elements 4 are short, the device is not easily affected by disturbance noise. That is, it is possible to detect magnetism with high accuracy. In addition, the arrangement relationship between the integrated circuit 3 and the plurality of magnetic detection elements 4 as described above increases the degree of integration on the wiring board 2, and it is easy to miniaturize the magnetic sensor device 1.

As described above, according to the present embodiment, it is possible to provide a magnetic sensor device that facilitates highly accurate magnetic detection and facilitates miniaturization.

### (Second embodiment)

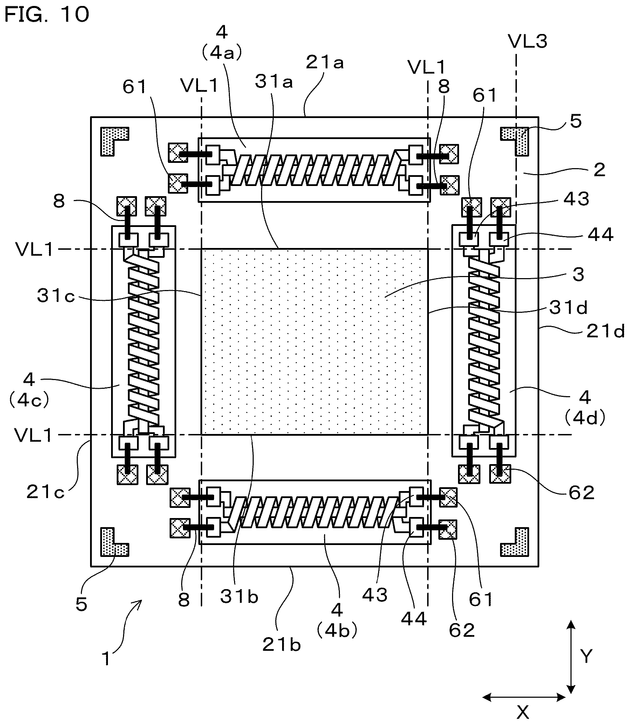

Fig. 10 is a plan view of a magnetic sensor device according to a second embodiment. The present embodiment (Fig. 10) is different from the first embodiment (Fig. 1) in that four relay pads 61, 62 are formed at each of the four corners of the wiring board 2. Hereinafter, different points will be mainly described.

In the drawing, four relay pads 61, 62 are formed near each of the four corners of the wiring board 2, and are formed by printing on the upper face of the wiring board 2.

When viewed in the direction normal to the wiring board 2, the relay pads 61 and 62 are formed at positions interposed between the virtual straight line VL1 obtained by extending each of the four edges 31a, 31b, 31c, and 31d of the integrated circuit 3 and the virtual straight line VL3 obtained by extending a contour line, of the MI element 4, close to each of the edges 21a, 21b, 21c, and 21d of the wiring board 2 in the width direction.

The relay pads 61 and 62 are connected to the wire pad 43 of the MI element 4 by the bonding wire 8. That is, each of the MI elements 4 is independent, and can be individually controlled.

As described above, according to the magnetic sensor device 1 of the second embodiment described with reference to the drawing, in the magnetic sensor device 1, the relay pad 61 and the wire pad 43 of the MI element 4 are connected in a one-to-one basis by the bonding wire 8. As a result, the MI elements 4a, 4b, 4c, and 4d disposed along the four edges can be more independently and easily controlled. This means that a range of control of the MI elements 4 is widened. In addition, it is also possible to reduce the size of the magnetic sensor device 1 while implementing the above-described functions.

Other than the above, configurations and effects similar to those of the first embodiment are obtained.

### (Third embodiment)

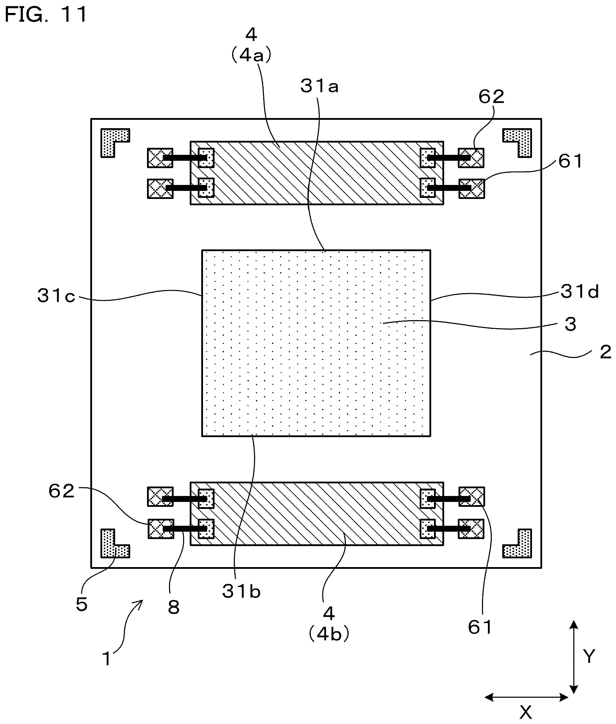

Fig. 11 is a plan view of a magnetic sensor device according to a third embodiment. The present embodiment (Fig. 11) is different from the second embodiment (Fig. 10) in that the MI elements 4c and 4d having the magnetism sensing direction in the Y direction are not mounted. Hereinafter, different points will be mainly described.

In the drawing, the number of the MI elements 4 mounted on the wiring board 2 is two. In the magnetic sensor device 1, the MI elements 4a and 4b are disposed at positions along two edges 31a and 31b of the integrated circuit 3, the two edges being opposite each other. The two MI elements 4 direct the magnetism sensing direction in the X direction. The number of relay pads 61 and 62 formed on the wiring board 2 is eight in total. Although the above configuration is described in the X direction, the same applies to the Y direction in which the physical position is rotated by 90 degrees.

As described above, the magnetic sensor device 1 according to the third embodiment described with reference to the drawing is different from the magnetic sensor devices 1 according to the first embodiment and the second embodiment in that the MI elements 4 whose magnetism sensing direction is the Y direction is omitted. Therefore, as compared with the first embodiment and the second embodiment, the size in the X direction can be reduced, so that the magnetic sensor device 1 can be further downsized.

Other than the above, configurations and effects similar to those of the first embodiment are obtained.

### (Fourth embodiment)

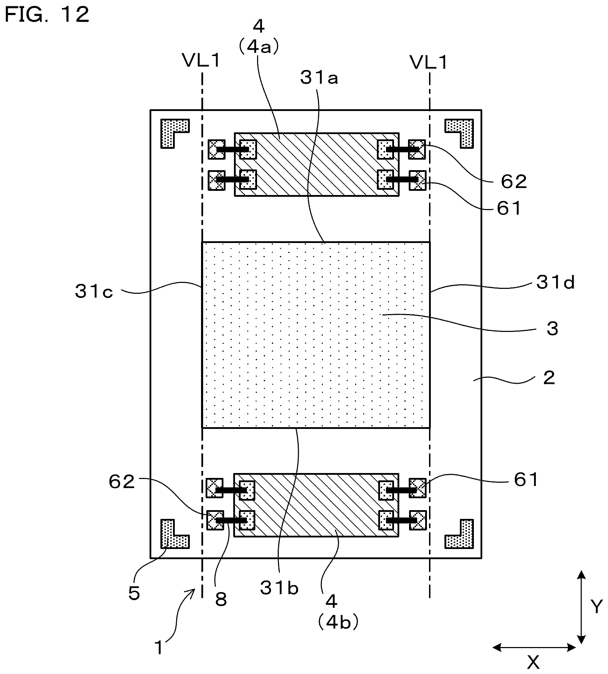

Fig. 12 is a plan view of a magnetic sensor device 1 according to a fourth embodiment. As illustrated in the drawing, in the magnetic sensor device 1 of the present embodiment, the longitudinal lengths of the MI elements 4a and 4b are reduced as compared with those in the magnetic sensor device 1 of the third embodiment (Fig. 11). Hereinafter, different points will be mainly described.

In the drawing, the relay pads 61 and 62 are disposed inside the virtual straight line VL1 in the X direction. Here, the virtual straight line VL1 is a straight line obtained by extending, in the Y direction, each of the edges 3c and 3d of the integrated circuit 3 in the X direction.

As described above, according to the magnetic sensor device 1 according to the fourth embodiment described with reference to the drawing, the size of the magnetic sensor device 1 in the X direction is reduced as compared with that of each of the first embodiment, the second embodiment, and the third embodiment, so that the magnetic sensor device 1 can be further downsized.

Other than the above, configurations and effects similar to those of the first embodiment are obtained.

### (Fifth embodiment)

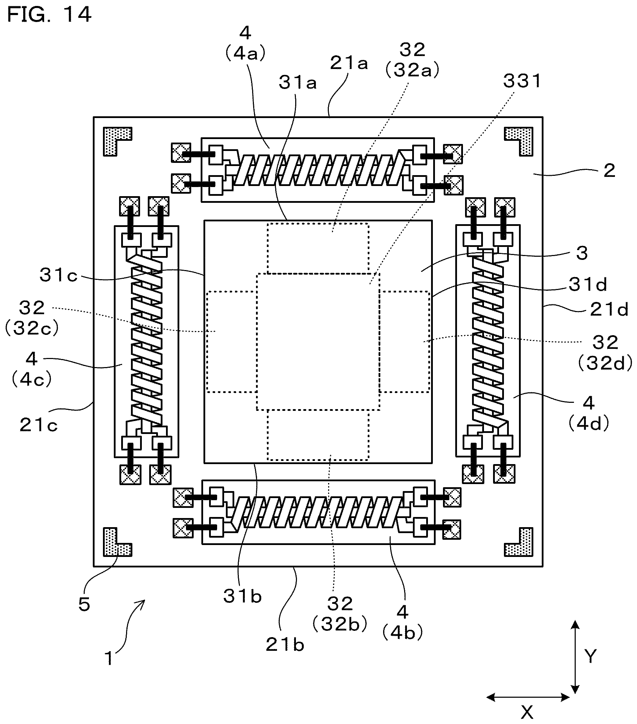

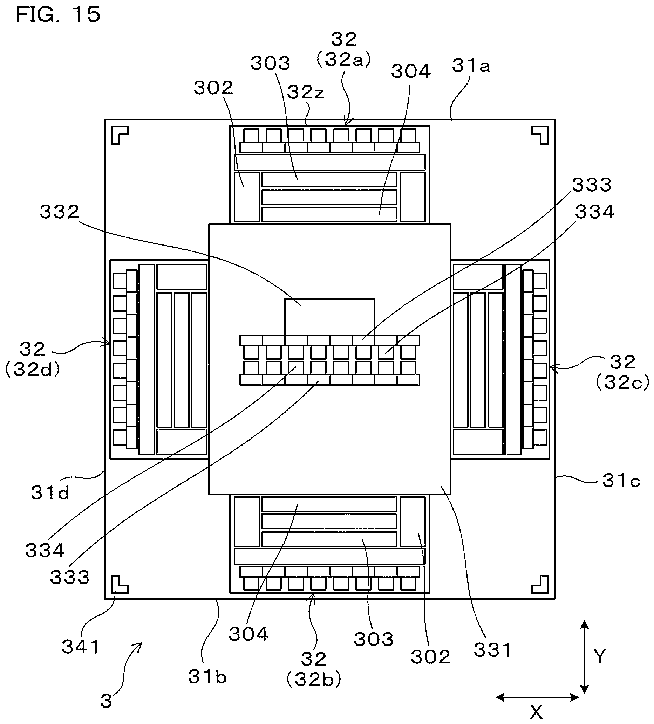

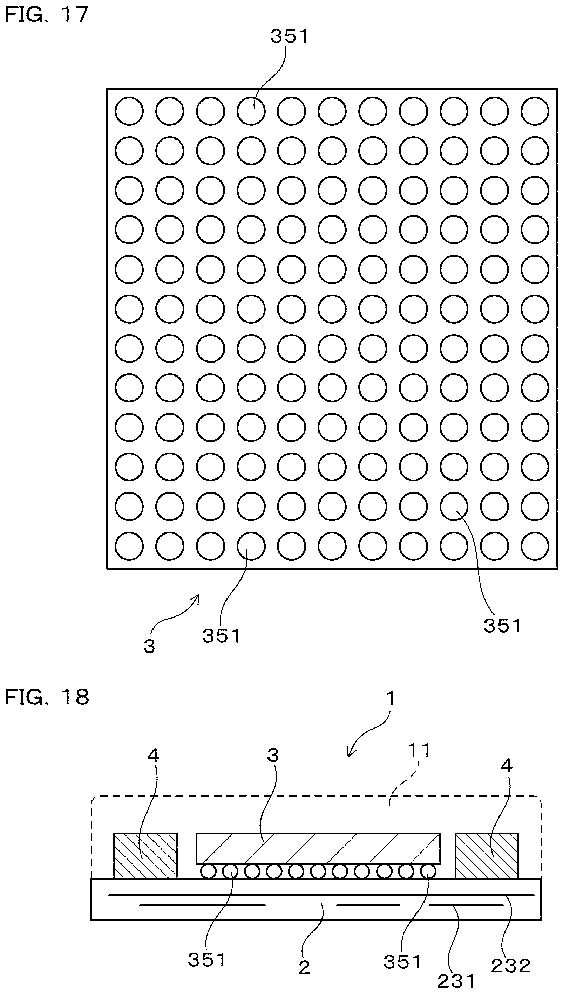

Fig. 14 is a plan view of a magnetic sensor device 1 according to a fifth embodiment. In the present embodiment, the plurality of magnetic detection elements 4, the integrated circuit 3, and the like are formed on the wiring board 2. As described with reference to Figs. 1 and 3, the plurality of magnetic detection elements 4 and the integrated circuit 3 are connected via the relay pads 61 and 62 on the wiring board 2, the connection wiring 12, and the connection pad 22. Here, the configuration of the integrated circuit 3 will be described in detail. The back face of the integrated circuit 3 is a silicon substrate. On the front face of the integrated circuit 3, solder balls (see reference numeral 351 in Figs. 17 and 18 described later) formed on connection pads for connection to the wiring board 2 are disposed. In order to connect such a form of the integrated circuit 3 to the wiring board 2, the integrated circuit 3 is turned upside down, and the solder balls are bonded (flip-chip mounted) to the wiring board 2. That is, the integrated circuit 3 illustrated in Fig. 14 represents a state in which the integrated circuit 3 illustrated in Fig. 15 is turned back.

Fig. 15 is a plan view of the integrated circuit 3 according to the present embodiment. The integrated circuit 3 includes a plurality of analog circuit units 32 connected to the plurality of magnetic detection elements 4, respectively. In the present embodiment, the integrated circuit 3 includes the analog circuit units 32, a digital circuit unit 331, and an output circuit 332. In the present embodiment, the integrated circuit 3 includes four analog circuit units 32a, 32b, 32c, and 32d electrically connected to the four magnetic detection elements 4a, 4b, 4c, and 4d, respectively.

The analog circuit units 32 each include at least a current application circuit 302, a sample hold circuit 303, and an AD conversion circuit 304. The current application circuit 302 is a circuit that applies a current to the magnetic detection element 4. In the present embodiment, the current application circuit 302 is a pulse energization circuit that applies a pulse current to the magnetic detection element 4 (more specifically, the magnetism sensing body 41 of the MI element 4). Hereinafter, it is also referred to as a pulse energization circuit 302. The current application circuit 302 is not limited to a pulse energization circuit, and may be, for example, a circuit that applies a high-frequency current to the magnetic detection element 4. An output signal of the magnetic detection element 4 is input to the sample hold circuit 303. The AD conversion circuit 304 converts an analog signal temporarily stored in the sample hold circuit 303 into a digital signal.

The analog circuit units 32 and the magnetic detection elements 4 connected to each other are adjacent to each other with the edges 31a, 31b, 31c, and 31d of the integrated circuit 3 interposed therebetween, respectively. That is, as illustrated in Fig. 14, the analog circuit unit 32a and the magnetic detection element 4a are adjacent to each other with the edge 31a of the integrated circuit 3 interposed therebetween, the analog circuit unit 32b and the magnetic detection element 4b are adjacent to each other with the edge 31b of the integrated circuit 3 interposed therebetween, the analog circuit unit 32c and the magnetic detection element 4c are adjacent to each other with the edge 31c of the integrated circuit 3 interposed therebetween, and the analog circuit unit 32d and the magnetic detection element 4d are adjacent to each other with the edge 31d of the integrated circuit 3 interposed therebetween.

The analog circuit units 32 each have an elongated shape, and the longitudinal directions of the analog circuit units 32 are respectively parallel to the edges 31a, 31b, 31c, and 31d of the integrated circuits 3 on an adjacent side.

As illustrated in Figs. 14 and 15, the four analog circuit units 32a, 32b, 32c, and 32d are disposed at positions along the four edges 31a, 31b, 31c, and 31d of the integrated circuit 3, respectively, when viewed in the direction normal to the wiring board 2. When viewed in the direction normal to the wiring board 2, the output circuit 332 that outputs a signal from the integrated circuit 3 to the outside is disposed between the plurality of analog circuit units 32.

In the present embodiment, when viewed in the direction normal to the wiring board 2, the output circuit 332 is disposed between the plurality of analog circuit units 32a and 32b disposed at positions along the two edges 31a and 31b of the integrated circuit 3, the two edges being opposite each other, and between the plurality of analog circuit units 32c and 32d disposed at positions along the other two edges 31c and 31d of the integrated circuit 3, the other two edges being opposite each other.

The output circuit 332 is formed in a region of the digital circuit unit 331 provided in a central region of the integrated circuit 3. The digital circuit unit 331 is disposed between the four analog circuit units 32a, 32b, 32c, and 32d.

An alignment mark 341 is formed near each of four corners of the integrated circuit 3. The alignment mark 341 has a substantially L shape, but the shape is not particularly limited.

In the region of the digital circuit unit 331, a plurality of communication pads 334 for connecting the output circuit 332 to the outside is further provided. An IO protection circuit 333 that protects the circuit from an elector static discharge (ESD) surge applied to the input terminal is provided between the output circuit 332 and the pad 334.

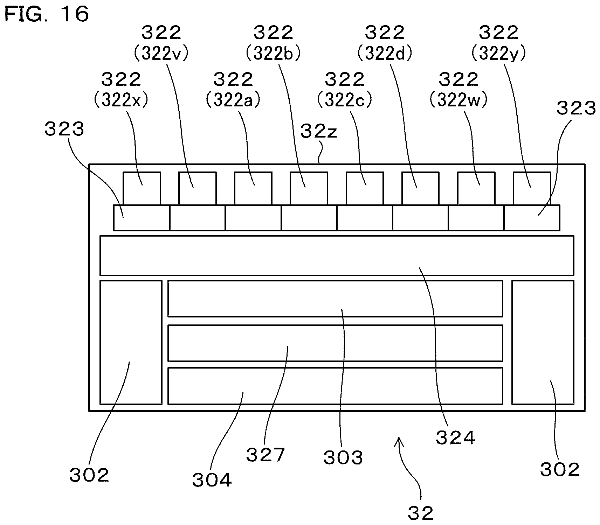

Fig. 16 is a plan view of the analog circuit unit 32 according to the fifth embodiment.

The analog circuit unit 32 is provided with the pulse energization circuit 302, the sample hold circuit 303, and the AD conversion circuit 304 described above, and is further provided with an amplifier circuit 327, a plurality of IO protection circuits 323, and a plurality of pads 322.

The plurality of pads 322 is disposed along the longitudinal direction of the analog circuit unit 32. As illustrated in Figs. 15 and 16, the plurality of pads 322 is disposed along an edge, of the analog circuit unit 32, opposite to an edge adjacent to the digital circuit unit 331. That is, the plurality of pads 322 is disposed at positions along the respective edges 31a, 31b, 31c, and 31d of the integrated circuit 3. Figs. 15 and 16 illustrate a state in which the plurality of pads 322 is disposed in a line, but the present disclosure is not limited thereto. It is also possible to arrange the plurality of pads 322 by shifting the distances from the edges 31a, 31b, 31c, and 31d, for example, by disposing the plurality of pads 322 in a staggered manner.

Each of the plurality of IO protection circuits 323 and each of the plurality of pads 322 are paired. The IO protection circuits 323 are provided adjacent to the inner side of the plurality of pads 322 in the integrated circuit 3. The positional relationship between the pads 322 and the IO protection circuits 323 is not particularly limited. For example, in the thickness direction of the integrated circuit 3, the pads 322 may be stacked on the IO protection circuits 323, or the pads 322 and the IO protection circuits 323 may be disposed side by side in a direction along the front face of the integrated circuit 3 without being stacked.

The analog circuit unit 32 receives an analog signal of the magnetic detection element 4 by the pads 322, the IO protection circuits 323, and the sample hold circuit 303. The sample hold circuit 303 temporarily stores the analog signal of the magnetic detection element 4. The amplifier circuit 327 amplifies the signal of the sample hold circuit 303. The analog signal amplified by the amplifier circuit 327 is converted into a digital signal by the AD conversion circuit 304. A wiring region 324 that connects the IO protection circuits 323 and the sample hold circuit 303 is provided between the IO protection circuits and the sample hold circuit.

Here, an example of arrangement of a plurality of elements in the analog circuit unit 32 will be described in detail.

As described above, the plurality of pads 322 is disposed along one edge of the analog circuit unit 32. The end edge where the plurality of pads 322 is adjacent to each other is referred to as a first end edge 32z. The plurality of IO protection circuits 323 is disposed adjacent to the plurality of pads 322 on a side opposite to the first end edge 32z with respect to the pads 322. Then, the wiring region 324 is formed at a position adjacent to the plurality of IO protection circuits 323, the position being opposite to positions of the plurality of pads 322. The wiring region 324 is formed long in the arrangement direction of the plurality of IO protection circuits 323, that is, long in the longitudinal direction of the analog circuit unit 32. The sample hold circuit 303 is disposed at a position adjacent to the wiring region 324, the position being opposite to positions of the plurality of IO protection circuits 323. The sample hold circuit 303 is also formed to be long in the longitudinal direction of the analog circuit unit 32. However, the length of the sample hold circuit 303 in the longitudinal direction is shorter than that of the wiring region 324. The amplifier circuit 327 is disposed at a position adjacent to the sample hold circuit 303, the position being opposite to the position of the wiring region 324. Furthermore, the AD conversion circuit 304 is disposed at a position adjacent to the amplifier circuit 327, the amplifier circuit 327 being adjacent to the sample hold circuit 303. The amplifier circuit 327 and the AD conversion circuit 304 also have a shape elongated in the longitudinal direction of the analog circuit unit 32. The length of each of the amplifier circuit 327 and the AD conversion circuit 304 in the longitudinal direction is substantially equal to the length of the sample hold circuit 303 in the longitudinal direction. In addition, the pulse energization circuits 302 are disposed at positions adjacent to both sides of the sample hold circuit 303, the amplifier circuit 327, and the AD conversion circuit 304 in the longitudinal direction.

The four analog circuit units 32a, 32b, 32c, and 32d have the same structure. The arrangement directions of the four analog circuit units 32a, 32b, 32c, and 32d in the integrated circuit 3 are different from each other, and all of them are disposed such that the pad 322 is located at the outer side as described above (see Fig. 15).

Some of the plurality of pads 322 in each analog circuit unit 32 are electrically connected to the magnetic detection element 4.

Here, the connection of the plurality of pads 322 will be described in detail.

More specifically, each of the plurality of pads 322 is connected as follows, for example. Pads 322x and 322y are electrically connected to both ends of the magnetism sensing body 41 of the MI element 4, respectively, and pads 322v and 322w are electrically connected to both ends of the detection coil 42 of the MI element 4, respectively. Pads 322a, 322b, 322c, and 322d are electrically connected to a power source or a ground.

Fig. 17 is a plan view of a back face of the integrated circuit 3 according to the fifth embodiment.

A plurality of solder balls 351 is uniformly disposed on the back face of the integrated circuit 3. Although not illustrated, the pads 322 and 334 in the integrated circuit 3 illustrated in Figs. 15 and 16 are connected to some of the solder balls 351 via wiring in the wiring board 2. Among the plurality of uniformly disposed solder balls 351, unnecessary dummy solder balls 351 are also disposed in order to make the shape of and the gap between the solder balls uniform in assembling. The material of the solder ball 351 is preferably a non-magnetic body, but may be a magnetic body.

Fig. 18 is a cross-sectional view of the magnetic sensor device 1 according to the fifth embodiment.

The magnetic detection elements 4 are mounted on the wiring board 2 by wire bonding, and the integrated circuit 3 is mounted (flip-chip mounted) by ball bonding with the back face on which the solder balls 351 are present facing the wiring board 2. The magnetic detection elements 4 mounted by wire bonding (bonding wires 8) are connected to the relay pads 61 and 62 (see Fig. 3) of the wiring board 2, and the integrated circuit 3 mounted by ball bonding (solder ball 351) is connected to the chip connection pad 22 (see Fig. 3) of the wiring board 2. The magnetic detection elements 4 and the integrated circuit 3 are connected by a wiring layer 231 of the wiring board 2. As a result, the pads 322 in the analog circuit units 32 and the pads 334 in the digital circuit unit 331 are connected to the wiring board 2, and can be connected to the outside of the integrated circuit 3, such as the magnetic detection elements 4, or the outside of the magnetic sensor device 1.

As illustrated in Fig. 18, the wiring board 2 includes the wiring layer 231 connected to the pad 334, and a conductor layer 232 having an electromagnetic shielding function such as a ground layer between the magnetic detection element 4 and the integrated circuit 3.

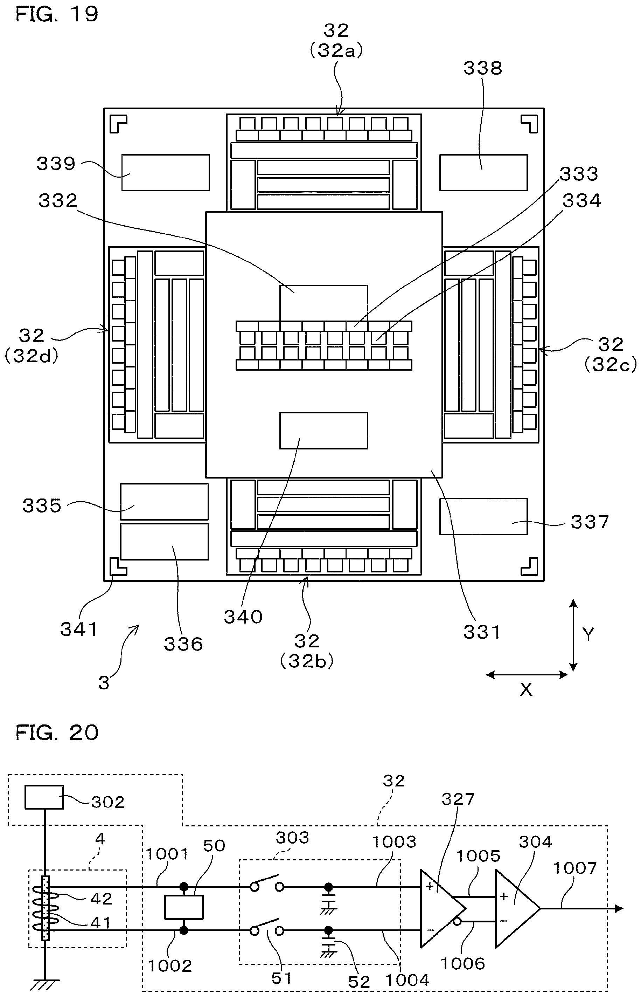

An example of a circuit configuration of the magnetic sensor device 1 of the present embodiment conforms to that illustrated in Fig. 20 described later.

As described above, in the present embodiment, the integrated circuit 3 includes the plurality of analog circuit units 32 electrically connected to the plurality of magnetic detection elements 4, so that the plurality of analog circuit units 32 can be independently controlled. For example, in a case where four magnetic detection elements 4 are provided, it is possible to have functions such as a high speed mode in which four magnetic signals are detected simultaneously (once) to output to the outside, a phase mode in which phases of the four magnetic signals are detected and sequentially output to the outside, and a low power consumption mode in which only two magnetic signals are output to the outside because the four magnetic signals are unnecessary. That is, the magnetic sensor device 1 can be made multifunctional.

In addition, the analog circuit units 32 and the magnetic detection elements 4 connected to each other are adjacent to each other with the edges 31a, 31b, 31c, and 31d of the integrated circuit 3 interposed therebetween, respectively. Therefore, distances between the plurality of magnetic detection elements 4 and the analog circuit units 32 of the integrated circuit 3 can be made equal. As a result, variations in detection signals due to physical arrangement can be suppressed, and variations due to the time of signal transmission/reception between the analog circuit units 32 and the magnetic detection elements 4 can also be reduced.

Furthermore, noise superimposed on the detection signal can be reduced by shortening the distances between the analog circuit units 32 and the magnetic detection elements 4 connected to each other.

When viewed in the direction normal to the wiring board 2, the output circuit 332 is disposed between the plurality of analog circuit units 32. This makes it easy to shorten the wiring distance between the output circuit 332 and each of the plurality of analog circuit units 32. As a result, the processing speed of the detection signals of the magnetic detection elements 4 can be easily increased, and the superimposition of noise can be reduced. In addition, it is easy to reduce variations in wiring distances between the output circuit 332 and the plurality of analog circuit units 32. In addition, since a distance between the output circuit 332 and the magnetic detection element 4 can be secured, it is possible to suppress an influence of a communication signal between the output circuit 332 and the outside on the magnetic detection elements 4.

In particular, by disposing the output circuit 332 in the central region of the integrated circuit 3, the physical distance to each of the plurality of analog circuit units 32 is equal, and the influence of thermal noise due to an operation current generated in the output circuit 332, the power supply, and the ground can be made substantially equal for each magnetic detection element 4.

The longitudinal direction of the analog circuit units 32a, 32b, 32c, and 32d are respectively parallel to the edges 31a, 31b, 31c, and 31d of the integrated circuits 3 on an adjacent side. As a result, the distances between the analog circuit units 32 and the magnetic detection elements 4 can be shortened.

The integrated circuit 3 is flip-chip mounted on the wiring board 2. As a result, the output circuit 332 can be disposed in the central region of the integrated circuit 3, and a signal can be easily output to the outside via the pad 334. In addition, since the integrated circuit 3 is flip-chip mounted on the wiring board 2, it is not necessary to use a bonding wire for connection between the integrated circuit 3 and the wiring board 2. Therefore, it is possible to eliminate the influence of the magnetic field caused by the current flowing through the bonding wire on the integrated circuit 3, which is concerned in the case of wire bonding mounting.

Other than the above, configurations and effects similar to those of the second embodiment are obtained.

### (Sixth embodiment)

Fig. 19 is a plan view of a magnetic sensor device 1 according to a sixth embodiment. In the present embodiment, changes from the fifth embodiment (Fig. 15) will be described in detail.

The integrated circuit 3 has a PLL circuit 335, a BGR circuit 336, an internal power supply generation circuit 337, a fuse circuit 338, and a decoupling circuit 339 in a region where the digital circuit unit 31 and the four analog circuit units 32 are not formed. These circuits are formed in spaces adjacent to the analog circuit units 32a and 32b on both sides in the X direction and also adjacent to the analog circuit units 32c and 32d on both sides in the Y direction.

The PLL circuit 335 is a circuit including a frequency divider, a multiplier, a phase comparator, and a voltage controlled oscillator (VCO), and generates a clock necessary for the integrated circuit 3 based on a clock signal input from the outside. The BGR circuit 336 generates an absolute reference voltage (or current) that does not depend on a power supply voltage, a temperature, a process, and the like. The internal power supply generation circuit 337 is a circuit that generates an internal power supply required by the integrated circuit 3. The fuse circuit 338 is a circuit that turns off a MOSFET and cuts off a load (resistance) when detecting an overcurrent. The fuse circuit 338 outputs a signal of "1" when a load (resistance) is disconnected, and outputs a signal of "0" when the load (resistance) is not disconnected. A plurality of fuses is disposed in the fuse circuit 338. The digital circuit unit 31 sets a register and a product code by combining signals of a plurality of fuses. The decoupling circuit 339 is a circuit that suppresses noises of a power source and a ground of the analog circuit unit 32 and the digital circuit unit 331.

Furthermore, the digital circuit unit 331 in the integrated circuit 3 has an SRAM 340 in addition to the control circuit that controls the analog circuit unit 32, the output circuit 332, and the like. The SRAM 340 mainly temporarily stores the digital signal generated by the AD conversion circuit 304. The SRAM 340 is also used in an arithmetic processing circuit. Although not illustrated, the arithmetic processing circuit is part of the digital circuit unit 331. The arithmetic processing circuit requires a plurality of signals (information). As an example, average addition (processing) or the like is performed using a plurality of digital signals generated by the AD conversion circuit 328, and then data of arithmetic processing is temporarily stored according to the situation.

Fig. 20 illustrates an example of part of the circuit configuration of the magnetic sensor device 1 of the present embodiment. This drawing illustrates one of the plurality of MI elements 4 included in the magnetic sensor device 1 and one analog circuit unit 32 connected thereto. The pulse energization circuit 302 can control flowing and stopping of a pulse current to the magnetism sensing body 41 of the MI element 4. By this control, a voltage (induced electromotive force) is generated at both ends of the detection coil 42 of the MI element 4. Voltages (signals) 1001 and 1002 generated at both ends of the detection coil 42 are input to the sample hold circuit 303. The input signals 1001 and 1002 are temporarily stored in the sample hold circuit 303. Here, the sample hold circuit 303 includes a switch 51 and a capacitor 52. Next, temporarily stored analog signals 1003 and 1004 are amplified by the amplifier circuit 327. Analog signals 1005 and 1006 amplified by the amplifier circuit 327 are converted from analog signals to digital signals 1007 by the AD conversion circuit 304. Note that the analog signals 1001 and 1002 are pre-charged to a predetermined potential by a pre-charge circuit 50 for a certain period.

In the present embodiment, by efficiently disposing each circuit in the integrated circuit 3, it is possible to incorporate multi-functions without increasing the occupied area.

Other than the above, configurations and effects similar to those of the fifth embodiment are obtained.

### (Seventh embodiment)

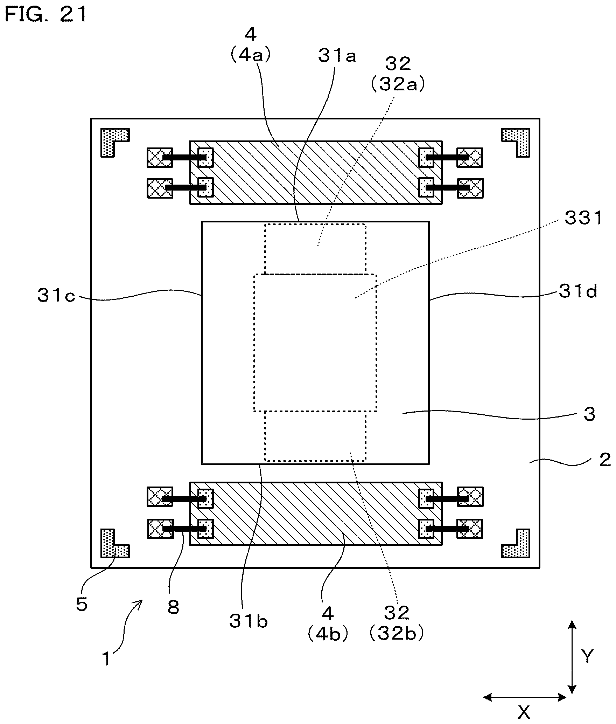

Fig. 21 is a plan view of a magnetic sensor device 1 according to a seventh embodiment. In the present embodiment, changes from Fig. 14 will be described in detail. The present embodiment is different from the fifth embodiment (Fig. 14) in that the magnetic detection elements 4c and 4d having a magnetism sensing direction in the Y direction are not mounted. Accordingly, the present embodiment is different from the fifth embodiment in that the analog circuit unit 32 is not provided at a position adjacent to the two edges 31c and 31d of the integrated circuit 3 along the Y direction.

As in the third embodiment (Fig. 11), the magnetic sensor device 1 of the present embodiment includes two magnetic detection elements 4a and 4b having a magnetism sensing direction in the X direction. The integrated circuit 3 is provided with two analog circuit units 32a and 32b connected to the magnetic detection elements 4a and 4b, respectively.

Other than the above, configurations and effects are similar to those of the fifth embodiment.

As described above, the magnetic sensor device according to the present disclosure can provide a magnetic sensor device that facilitates highly accurate magnetic detection and is easily downsized.

The magnetic sensor device according to the present disclosure may be used in a wide variety of applications such as a foreign matter detection device that detects a foreign matter (magnetic body) mixed in food or the like, a magnetic detection device used in an automatic driving system in transportation equipment, a medical magnetic detection device that detects biomagnetism, and the like.

The present invention is not limited to the above embodiments, and can be applied to various embodiments without departing from the gist of the present invention.

Features of the present invention are as follows.
[1] A magnetic sensor device including:
   a wiring board;
   a plurality of magnetic detection elements mounted on the wiring board; and
   an integrated circuit mounted on the wiring board and electrically connected to the magnetic detection elements, the integrated circuit having a rectangular shape, wherein
   the plurality of magnetic detection elements is disposed outside the integrated circuit when viewed in a direction normal to the wiring board, and
   the magnetic detection elements whose magnetism sensing directions are parallel to each other are disposed at least at positions along two edges of the integrated circuit, the two edges being opposite each other.
[2] The magnetic sensor device according to [1], wherein the plurality of magnetic detection elements each has an elongated shape, and a longitudinal direction of each magnetic detection element is parallel to an edge of the integrated circuit on an adjacent side.
[3] The magnetic sensor device according to [1] or [2], including four or more of the magnetic detection elements, wherein the magnetic detection elements are disposed at positions respectively along four edges of the integrated circuit when viewed in a direction normal to the wiring board.
[4] The magnetic sensor device according to any one of [1] to [3], wherein on the wiring board, a relay pad constituting part of an electrical path between the integrated circuit and the magnetic detection elements and a connection wiring electrically connecting the relay pad and the integrated circuit are formed, each magnetic detection element is connected to the relay pad with a bonding wire, and the bonding wire is disposed at a position where the bonding wire does not overlap the integrated circuit when viewed in a direction normal to the wiring board.
[5] The magnetic sensor device according to [4], wherein the relay pad is disposed at a position farther from the integrated circuit than a virtual straight line obtained by extending each of four edges of the integrated circuit when viewed in a direction normal to the wiring board.
[6] The magnetic sensor device according to any one of [1] to [5], wherein the plurality of magnetic detection elements is a magneto-impedance element.
[7] The magnetic sensor device according to any one of [1] to [6], wherein the integrated circuit includes a plurality of analog circuit units connected to the plurality of magnetic detection elements, respectively, each of the analog circuit units includes at least a current application circuit configured to apply a current to a corresponding magnetic detection element, a sample hold circuit to which an output signal of the corresponding magnetic detection element is input, and an AD conversion circuit configured to convert an analog signal temporarily stored in the sample hold circuit into a digital signal, and the analog circuit unit and the corresponding magnetic detection element connected to each other are adjacent to each other with each edge of the integrated circuit interposed therebetween.
[8] The magnetic sensor device according to [7], wherein an output circuit configured to output a signal from the integrated circuit to an outside is disposed between the plurality of analog circuit units when viewed in a direction normal to the wiring board.
[9] The magnetic sensor device according to [7] or [8], wherein the plurality of magnetic detection elements each has an elongated shape, a longitudinal direction of each magnetic detection element is parallel to an edge of the integrated circuit on an adjacent side, the analog circuit unit has an elongated shape, and a longitudinal direction of the analog circuit unit is parallel to an edge of the integrated circuit on an adjacent side.
[10] The magnetic sensor device according to any one of [7] to [9], including four or more of the magnetic detection elements, wherein the magnetic detection elements are disposed at positions respectively along four edges of the integrated circuit when viewed in a direction normal to the wiring board, the integrated circuit includes four or more of the analog circuit units, and the analog circuit units are disposed at positions respectively along four edges of the integrated circuit when viewed in the direction normal to the wiring board.
[11] The magnetic sensor device according to [10], wherein when viewed in the direction normal to the wiring board, an output circuit configured to output a signal from the integrated circuit to an outside is disposed between the plurality of analog circuit units disposed at positions along two edges of the integrated circuit, the two edges being opposite each other, and between the plurality of analog circuit units disposed at positions along other two edges of the integrated circuit, the other two edges being opposite each other.
[12] The magnetic sensor device according to any one of [7] to [11], wherein the integrated circuit is flip-chip mounted on the wiring board.
[13] The magnetic sensor device according to any one of [7] to [12], wherein the plurality of magnetic detection elements is a magneto-impedance element, and the current application circuit is configured to apply a pulse current or a high-frequency current to the corresponding magnetic detection element.

## Claims

1. A magnetic sensor device comprising:
a wiring board;
a plurality of magnetic detection elements mounted on the wiring board; and
an integrated circuit mounted on the wiring board and electrically connected to the magnetic detection elements, the integrated circuit having a rectangular shape, wherein
the plurality of magnetic detection elements is disposed outside the integrated circuit when viewed in a direction normal to the wiring board, and
the magnetic detection elements whose magnetism sensing directions are parallel to each other are disposed at least at positions along two edges of the integrated circuit, the two edges being opposite each other.

2. The magnetic sensor device according to claim 1, wherein the plurality of magnetic detection elements each has an elongated shape, and a longitudinal direction of each magnetic detection element is parallel to an edge of the integrated circuit on an adjacent side.

3. The magnetic sensor device according to claim 1 or 2, comprising four or more of the magnetic detection elements, wherein the magnetic detection elements are disposed at positions respectively along four edges of the integrated circuit when viewed in a direction normal to the wiring board.

4. The magnetic sensor device according to claim 1 or 2, wherein on the wiring board, a relay pad constituting part of an electrical path between the integrated circuit and the magnetic detection elements and a connection wiring electrically connecting the relay pad and the integrated circuit are formed, each magnetic detection element is connected to the relay pad with a bonding wire, and the bonding wire is disposed at a position where the bonding wire does not overlap the integrated circuit when viewed in a direction normal to the wiring board.

5. The magnetic sensor device according to claim 4, wherein the relay pad is disposed at a position farther from the integrated circuit than a virtual straight line obtained by extending each of four edges of the integrated circuit when viewed in a direction normal to the wiring board.

6. The magnetic sensor device according to claim 1 or 2, wherein the plurality of magnetic detection elements is a magneto-impedance element.

7. The magnetic sensor device according to claim 1, wherein the integrated circuit includes a plurality of analog circuit units connected to the plurality of magnetic detection elements, respectively, each of the analog circuit units includes at least a current application circuit configured to apply a current to a corresponding magnetic detection element, a sample hold circuit to which an output signal of the corresponding magnetic detection element is input, and an AD conversion circuit configured to convert an analog signal temporarily stored in the sample hold circuit into a digital signal, and the analog circuit unit and the corresponding magnetic detection element connected to each other are adjacent to each other with each edge of the integrated circuit interposed therebetween.

8. The magnetic sensor device according to claim 7, wherein an output circuit configured to output a signal from the integrated circuit to an outside is disposed between the plurality of analog circuit units when viewed in a direction normal to the wiring board.

9. The magnetic sensor device according to claim 7 or 8, wherein the plurality of magnetic detection elements each has an elongated shape, a longitudinal direction of each magnetic detection element is parallel to an edge of the integrated circuit on an adjacent side, the analog circuit unit has an elongated shape, and a longitudinal direction of the analog circuit unit is parallel to an edge of the integrated circuit on an adjacent side.

10. The magnetic sensor device according to claim 7 or 8, comprising four or more of the magnetic detection elements, wherein the magnetic detection elements are disposed at positions respectively along four edges of the integrated circuit when viewed in a direction normal to the wiring board, the integrated circuit includes four or more of the analog circuit units, and the analog circuit units are disposed at positions respectively along four edges of the integrated circuit when viewed in the direction normal to the wiring board.

11. The magnetic sensor device according to claim 10, wherein when viewed in the direction normal to the wiring board, an output circuit configured to output a signal from the integrated circuit to an outside is disposed between the plurality of analog circuit units disposed at positions along two edges of the integrated circuit, the two edges being opposite each other, and between the plurality of analog circuit units disposed at positions along other two edges of the integrated circuit, the other two edges being opposite each other.

12. The magnetic sensor device according to claim 11, wherein the integrated circuit is flip-chip mounted on the wiring board.

13. The magnetic sensor device according to claim 7 or 8, wherein the plurality of magnetic detection elements is a magneto-impedance element, and the current application circuit is configured to apply a pulse current or a high-frequency current to the corresponding magnetic detection element.
